# EUROPÄISCHE PATENTSCHRIFT

(11) **EP 3 268 304 B1**
(45) Veröffentlichungstag und Bekanntmachung des Hinweises auf die Patenterteilung: **25.08.2021**
(21) Anmeldenummer: 16710114.6
(22) Anmeldetag: 04.03.2016
(51) Int. Cl.: B81B 3/00, G01L 9/00

(54) **MEMS-SENSOR, INSB. DRUCKSENSOR**
MEMS SENSOR, IN PARTICULAR A PRESSURE SENSOR
CAPTEUR MEMS, NOTAMMENT CAPTEUR DE PRESSION

(30) Priorität: 10.03.2015 DE 102015103485
(43) Veröffentlichungstag der Anmeldung: 17.01.2018
(73) Patentinhaber: Endress+Hauser SE+Co. KG, 79689 Maulburg (DE)
(72) Erfinder: TEIPEN, Rafael, 10407 Berlin (DE); LEMKE, Benjamin, 12051 Berlin (DE)
(74) Vertreter: Andres, Angelika Maria
(86) Internationale Anmeldenummer: PCT/EP2016/054657
(87) Internationale Veröffentlichungsnummer: WO 2016/142291

(56) Entgegenhaltungen:
- DE-B3- 10 393 943
- US-A1- 2002 014 124
- US-A1- 2014 137 652

## Beschreibung

Die vorliegende Erfindung betrifft einen MEMS-Sensor zur messtechnischen Erfassung einer Messgröße, der mehrere aufeinander angeordnete Lagen, insb. Siliziumlagen, umfasst, dessen Lagen mindestens eine innere Lage umfassen, die zwischen einer ersten Lage und einer zweiten Lage angeordnet ist, und in dessen inneren Lage mindestens eine senkrecht zur Ebene der inneren Lage durch die innere Lage hindurch verlaufende Ausnehmung vorgesehen ist, an die außenseitlich zumindest abschnittweise ein ein Verbindungselement bildender Bereich der inneren Lage angrenzt, der mit der ersten Lage und der zweiten Lage verbundenen ist.

MEMS-Sensoren sind Mikro-Elektromechanische Systeme, die zur messtechnischen Erfassung einer Messgröße, z.B. eines Drucks, eines Masse- oder eines Volumendurchflusses, einer Dichte, einer Viskosität, einer Temperatur, eines pH-Werts oder einer elektrischen Leitfähigkeit eingesetzt werden.

MEMS-Sensoren werden regelmäßig aus aufeinander angeordneten Lagen, insb. Siliziumlagen, aufgebaut, und unter Verwendung von in der Halbleitertechnologie üblichen Verfahren, wie z.B. Ätzprozessen, Oxidationsverfahren, Implantationsverfahren, Bondverfahren und/oder Beschichtungsverfahren hergestellt. Dabei werden die einzelnen Lagen, sowie ggfs. zwischen benachbarten Lagen vorgesehene Verbindungsschichten, z.B. Isolationsschichten, entsprechend der ihnen im Sensor zukommenden Funktion präpariert bzw. strukturiert.

MEMS-Sensoren umfassen regelmäßig Komponenten, die einer mechanischen Belastung ausgesetzt sein können. Ein Beispiel hierfür sind Funktionselemente von im MEMS-Sensor integrierten elektromechanischen Wandlern, die einer von der zu erfassenden Messgröße abhängigen mechanischen Belastung ausgesetzt werden, die vom Wandler in eine von der Messgröße abhängige elektrische Größe umwandelt wird.

Mechanische Belastungen bewirken zwangsläufig Spannungen die einzelne Sensorkomponenten und/oder mit einzelnen Sensorkomponenten verbundene Komponenten mechanisch beanspruchen. Das stellt solange kein Problem dar, wie die Belastungen eine für den Sensor vorgegebene häufig als Überlastfestigkeit bezeichnete Belastungsgrenze nicht überschreiten. Es kommt jedoch in der Praxis immer wieder vor, dass Sensoren Überbelastungen ausgesetzt werden.

Die Gefahr einer Überbelastung ist insb. bei Differenzdrucksensoren besonders groß, die dazu eingesetzt werden Druckdifferenzen Δp zwischen zwei im Vergleich zur Druckdifferenz Δp großen Drücken p₁, p₂ zu messen. Da diese Sensoren empfindlich genug sein müssen, um die dem kleineren der beiden Drücken entsprechenden Systemdruck überlagerte Druckdifferenz Δp messtechnisch erfassen zu können, stellen vor allem einseitige Überlasten, bei denen nur eine Seite einer Messmembran des Differenzdrucksensors mit einem hohen Druck beaufschlagt wird, dem kein auf die gegenüberliegenden Seite der Messmembran einwirkender Gegendruck entgegenwirkt, ein Problem dar.

Dabei sind Sensoren, die Bereiche mit kantiger Formgebung aufweisen, besonders empfindlich gegenüber mechanischen Belastungen, da sich an harten Kanten Kerbspannungen konzentrieren, die im Falle einer Überbelastung Spannungsrisse oder sogar Spannungsbrüche verursachen können.

Ein Beispiel hierfür sind piezoresistive Drucksensoren, die eine mit einem zu messenden Druck beaufschlagbare Messmembran aufweisen. Diese Drucksensoren werden regelmäßig hergestellt, in dem in einen Siliziumwafer mittels eines anisotropen Ätzverfahren, z.B. eines mit Kaliumhydroxid (KOH) ausgeführten anisotropen Ätzverfahren, eine Ausnehmung eingeätzt wird. Dabei bildet ein die Ausnehmung umgebender Rand des Sensorchips einen Träger, der die durch die Ausnehmung frei gelegte Messmembran umgibt. Anisotrope Ätzverfahren erzeugen jedoch harte Kanten am Übergang von der Messmembran zum Träger, in denen sich Kerbspannungen konzentrieren.

Zur Lösung dieses Problems ist in der DE 10 2008 035 017 A1 beschrieben, die die Messmembran frei legenden Ausnehmung mittels einer Kombination aus einem anisotropen und einem isotropen Ätzverfahren zu erzeugen. Dabei wird mit dem anisotropen Ätzverfahren eine Ausnehmung erzeugt, die sich zur Erhöhung der mechanischen Stabilität in Richtung der Messmembran konisch verjüngt. Anschließend werden in einem nachgeschalteten isotropen Ätzverfahren die beim anisotropen Ätzen am Übergang zur Messmembran entstehenden harten Kanten abgerundet. Durch das Abrunden der Kanten werden Kerbspannungen reduziert.

Eine alternative Ausführungsform eines piezoresistiven Drucksensors ist in der DE 10 2007 010 913 A1 beschrieben. Dieser umfasst zwei Lagen aus Silizium, die über eine zwischen den beiden Lagen angeordnete Verbindungschicht, nämlich eine Oxidschicht, miteinander verbunden sind. Bei diesem Drucksensor sind auf einer der Lagen piezoresistive Elemente vorgesehen und die zweite Lage weist eine Ausnehmung auf, über die ein die Messmembran bildender Bereich der ersten Lage und der damit verbunden Oxidschicht frei gelegt ist. Um auch geringe Drücke mit einem geringen Linearitätsfehler messtechnisch erfassen zu können, ist auf der den piezoresistiven Elementen gegenüberliegenden Seite der Messmembran in der Oxidschicht ein Nut vorgesehen, die dazu dient die durch den auf die Messmembran einwirkenden Druck erzeugten Spannungen an den Orten zu konzentrieren, an denen sich die piezoresistiven Elemente befinden. Zur Erhöhung der Bestfestigkeit des Sensors weist die Nut eine im Querschnitt abgerundete Geometrie auf, und die Ausnehmung in der zweiten Lage weist vorzugsweise eine sich in Richtung der Oxidschicht konisch verjüngende Mantelfläche auf.

Die Kombination einer die Stabilität erhöhenden sich konisch verjüngenden Ausnehmung mit einem z.B. durch eine abgerundete Nut oder eine abgerundete Kante bewirkten abgerundeten Übergang setzt jedoch voraus, dass genügend Platz für eine sich konisch verjüngende und damit zwangsläufig an deren offenen Seite größeren Ausnehmung zur Verfügung steht, und dass die abzurundende Kante in einem für den Einsatz eines isotropen Ätzverfahrens ausreichenden Maße zugänglich ist.

Beide Voraussetzungen sind erfüllbar, wenn sich die Ausnehmung in einer äußeren und damit von einer Außenseite des MEMS-Sensors her zugänglichen Lage befindet.

Die Überlastfestigkeit von MEMS-Sensoren begrenzende Spannungskonzentrationen können jedoch auch an Orten im Inneren der Sensoren auftreten, die nicht ohne Weitere von außen zugänglich sind. Diese Situation ist bei MEMS-Sensoren gegeben, die eine im Inneren des Sensors eingeschlossene Ausnehmung aufweisen, an die mindestens ein Teilbereich einer Lage angrenzt, der unter Umständen mechanischen Belastungen ausgesetzt sein kann. Ein Beispiel hierfür sind in Drucksensoren mit einer unter einer mit einem Druck beaufschlagbaren Messmembran eingeschlossenen Druckkammer. Ein weiteres Beispiel sind durch innere Lage eines Sensors hindurch verlaufende Gräben, z.B. Isolationsgräben, die einen mit einer der beiden äußeren Lagen verbundenen und von der anderen beabstandeten Teilbereiche der inneren Lage außenseitlich zumindest abschnittweise umgeben. Es gibt auch MEMS-Sensoren, z.B. kapazitive Drucksensoren, bei denen die vorgenannten Beispiele in Kombination miteinander auftreten.

In der DE 103 93 943 B3 ist ein Differenzdrucksensor beschrieben,
- der mehrere aufeinander angeordnete Lagen, insb. Siliziumlagen, umfasst,
- dessen Lagen mindestens eine innere Lage umfassen, die zwischen einer ersten Lage und einer zweiten Lage angeordnet ist, und
- in dessen inneren Lage mindestens eine senkrecht zur Ebene der inneren Lage durch die innere Lage hindurch verlaufende Ausnehmung vorgesehen ist, an die außenseitlich zumindest abschnittweise ein ein Verbindungselement bildender Bereich der inneren Lage angrenzt, der mit der ersten Lage und der zweiten Lage verbundenen ist.

Der Differenzdrucksensor weist eine eine Messmembran umfassende erste Lage auf, die zwischen zwei Grundkörpern angeordnet ist. Jeder Grundkörper ist jeweils unter Einschluss einer Druckkammer mit der ersten Lage verbunden, und umfasst eine innere Lage und eine damit über eine Verbindungsschicht verbundene zweite Lage. Die inneren Lagen sind durch eine als Isolationsgraben ausgebildete Ausnehmung in einen das Verbindungselement bildenden äußeren Bereich und einen vom Verbindungselement allseitig außenseitlich umgegebenen inneren Bereich unterteilt. Die inneren Bereiche dienen als Elektroden und sind jeweils durch eine mit dem Isolationsgraben verbundene Ausnehmung in der inneren Lage von der Messmembran beabstandet. Jede Elektrode bildet zusammen mit der als Gegenelektrode dienenden ersten Lage einen Kondensator mit einer vom auf die Messmembran einwirkenden Druck abhängigen Kapazität.

Aus dem Stand der Technik ist ferner die US 2014/137652 A1 bekannt geworden, die einen Drucksensorchip, der eine Sensormembran und ein erstes und ein zweites Halteelement offenbart, beschreibt.

Um MEMS-Sensoren möglichst klein und stabil zu gestalten, ist man regelmäßig bemüht Ausnehmungen im Inneren von MEMS-Sensoren klein zu halten. Hierzu werden Ausnehmungen in inneren Lagen von MEMS-Sensoren außenseitlich vorzugsweise durch Mantelflächen begrenzt, die im Wesentlichen senkrecht zur ersten und senkrecht zur zweiten Lage verlaufen. Das führt zu im Wesentlichen rechtwinkligen Übergängen vom Verbindungselement zur ersten Lage und vom Verbindungselement zur zweiten Lage. Entsprechend führen auf die erste Lage, die zweite Lage und/oder das Verbindungselement einwirkende Kräfte zu Spannungskonzentrationen in den Übergangsbereichen, die die Überlastfestigkeit des Sensors begrenzen.

Es ist eine Aufgabe der vorliegenden Erfindung einen MEMS-Sensor mit einer im Sensor eingeschlossenen Ausnehmung anzugeben, der eine verbesserte Überlastfestigkeit aufweist.

Hierzu umfasst die Erfindung einen MEMS-Sensor zur messtechnischen Erfassung einer Messgröße,
- der mehrere aufeinander angeordnete Lagen, insb. Siliziumlagen, umfasst,
- dessen Lagen mindestens eine innere Lage umfassen, die zwischen einer ersten Lage und einer zweiten Lage angeordnet ist, und
- in dessen inneren Lage mindestens eine senkrecht zur Ebene der inneren Lage durch die innere Lage hindurch verlaufende Ausnehmung vorgesehen ist, an die außenseitlich zumindest abschnittweise ein ein Verbindungselement bildender Bereich der inneren Lage angrenzt, der mit der ersten Lage und der zweiten Lage verbundenen ist, und der die Ausnehmung ringförmig umgibt, wobei die erste Lage eine Messmembran umfasst, und die erste Lage unter Einschluss einer Druckkammer mit einem Grundkörper verbunden ist, der die innere Lage und die zweite Lage umfasst, wobei der MEMS-Sensor ein Drucksensor, insb. ein Absolutdruck-, ein Relativdruck- oder ein Differenzdrucksensor ist,
wobei eine die Ausnehmung außenseitlich zumindest abschnittweise begrenzende Mantelfläche des Verbindungselements
- in einem der erste Lage zugewandten Endbereich eine die Querschnittsfläche der Ausnehmung in Richtung der ersten Lage verkleinernde, abgerundete Formgebung aufweist, und
- in einem der zweiten Lage zugewandten Endbereich eine die Querschnittsfläche der Ausnehmung in Richtung der zweiten Lage verkleinernde, abgerundete Formgebung aufweist und sich dadurch auszeichnet, dass
zueinander benachbarte Lagen jeweils über eine zwischen den beiden benachbarten Lagen vorgesehene Isolationsschicht, insb. aus Siliziumdioxid, miteinander verbunden sind, und
das Verbindungselement im Bereich der inneren Lage durch die Ausnehmung vollständig von einem von der Ausnehmung umgebenen, als Elektrode dienenden weiteren Bereich getrennt ist.

Eine erste Weiterbildung zeichnet sich dadurch aus, dass
- mindestens eine innere Lage mindestens einen von der Ausnehmung umgebenen, weiteren Bereich aufweist, der mit der ersten Lage oder der zweiten Lage verbunden ist,
- mindestens eine innere Lage mindestens einen weiteren mit der ersten Lage oder der zweiten Lage verbundenen Bereich aufweist, der an eine senkrecht zur inneren Lage durch die innere Lagen hindurch verlaufende Ausnehmungen angrenzt, und
- eine die Ausnehmung zumindest abschnittweise außenseitlich begrenzende Mantelfläche des weiteren Bereichs in deren, der mit dem weiteren Bereich verbundenen Lage zugewandten Endbereich eine die Querschnittsfläche der Ausnehmung in Richtung der mit dem weiteren Bereich verbundenen Lage verkleinernde, abgerundete Formgebung aufweist.

Eine bevorzugte Ausgestaltung der letztgenannten Ausgestaltung sieht vor, dass
- die Verbindungsschichten eine im Vergleich zur Schichtdicke der Lagen geringe Schichtdicke, insb. eine Schichtdicke in der Größenordnung von einem oder mehreren Mikrometern, insb. ein Schichtdicke von 1 µm bis 5 µm, insb. 2 µm bis 4 µm, aufweisen,
- wobei die Lagen insb. eine Schichtdicke von größer gleich mehreren 10 µm aufweisen.

Eine weitere Ausgestaltung der Erfindung sieht vor, dass das Verbindungselement die Ausnehmung außenseitlich allseitig umgibt.

Eine weitere Ausgestaltung der Erfindung sieht vor, dass die innere Lage mindestens einen weiteren Bereich, insb. einen als Elektrode dienenden weiteren Bereich, insb. einen von einem Isolationsgraben, insb. einem durch die Ausnehmung gebildete Isolationsgraben, umgebenen weiteren Bereich umfasst.

Die erste Lage, weist vorzugsweise eine senkrecht zur Auslenkungsrichtung der Messmembran verlaufende Symmetrieebene auf, zu der die erste Lage symmetrisch ist, wenn sich die Messmembran in der Ruhelage befindet.

Eine Weiterbildung der letztgenannten bevorzugten Ausgestaltung sieht vor, dass
- die innere Lage über eine erste Verbindungsschicht mit der ersten Lage verbunden ist, und
- die erste Verbindungschicht eine die Messmembran frei gebende, eine Druckkammer bildende Aussparung aufweist.

Eine Ausgestaltung der bevorzugten Ausgestaltung oder deren Weiterbildung sieht vor, dass
- die innere Lage mindestens einen als Elektrode dienenden weiteren Bereich, insb. einen von einem Isolationsgraben, insb. einem durch die Ausnehmung gebildeten Isolationsgraben, umgebenen weiteren Bereich umfasst,
- die innere Lage über eine als Isolationsschicht ausgebildete zweite Verbindungsschicht mit der zweiten Lage verbunden ist,
- die Elektrode über die zweite Verbindungsschicht mit der zweiten Lage verbunden ist, und
- die Elektrode von der als Gegenelektrode hierzu dienenden ersten Lage beabstandet ist.

Eine Ausgestaltung der als Drucksensor ausgebildeten erfindungsgemäßen MEMS-Sensoren sieht vor, dass der Grundkörper eine durch den Grundkörper hindurch verlaufende Ausnehmung aufweist, die in der Druckkammer mündet.

Eine weitere Ausgestaltung der letztgenannten Ausgestaltung der als Drucksensor ausgebildeten erfindungsgemäßen MEMS-Sensoren sieht vor, dass auf einer dem Grundkörper gegenüberliegenden Seite der ersten Lage ein weiterer Grundkörper, insb. ein baugleicher weiterer Grundkörper vorgesehen ist, der unter Einschluss einer Druckkammer mit der ersten Lage verbunden ist.

Wie bereits oben erwähnt, weist die erste Lage vorzugsweise eine senkrecht zur Auslenkungsrichtung der Messmembran verlaufende Symmetrieebene auf, zu der die erste Lage symmetrisch ist, wenn sich die Messmembran in der Ruhelage befindet; ein erfindungsgemäßer Drucksensor mit zwei Grundkörpern, dient insbesondere als Differenzdrucksensor, wobei hier vorzugsweise der gesamte Aufbau des Drucksensors mit den beiden Grundkörpern, zumindest was die mechanisch bestimmenden Komponenten betrifft, symmetrisch zu der obigen Symmetrieebene ist.

Gemäß einer Weiterbildung der Erfindung weisen die abgerundeten Endbereiche einen in Abhängigkeit von der Schichtdicke der jeweiligen inneren Lage ausgewählten Krümmungsradius auf, der größer gleich 1 µm, insb. größer gleich 5 µm, insb. größer gleich 10 µm ist.

Weiter umfasst die Erfindung ein Verfahren zur Herstellung eines erfindungsgemäßen MEMS-Sensors, das sich dadurch auszeichnet, dass die Ausnehmung durch eine Kombination aus einem anisotropen Ätzverfahren und einem isotropen Ätzverfahren erzeugt wird.

Eine Weiterbildung des Verfahrens zeichnet sich dadurch aus, dass
- mittels eines anisotropen Ätzverfahrens, insb. mittels Reaktivem lonentiefenätzen (DRIE), ein Graben, insb. ein Graben mit im Wesentlichen senkrecht zur inneren Lage verlaufenden Seitenwänden, in der inneren Lage erzeugt wird, der sich bis zu einer vorgegebenen Ätztiefe in die innere Lage hinein erstreckt, diese aber nicht vollständig durchdringt, und
- mittels eines isotropen Ätzverfahrens, insb. mittels Reaktivem lonenätzen (RIE), aus dem Graben die durch die innere Lage hindurch verlaufende Ausnehmung erzeugt wird.

Eine Weiterbildung der letztgenannten Weiterbildung zeichnet sich dadurch aus, dass die Ätztiefe in Abhängigkeit von einer Schichtdicke der inneren Lage derart vorgegeben wird, dass eine Differenz zwischen der Schichtdicke der inneren Lage und der Ätztiefe einem zu erzeugenden Krümmungsradius der abgerundeten Endbereiche entspricht.

Die Erfindung und deren Vorteile werden nun anhand der Figuren der Zeichnung, in denen ein Ausführungsbeispiel dargestellt ist, näher erläutert. Gleiche Elemente sind in den Figuren mit den gleichen Bezugszeichen versehen.
- Fig. 1: zeigt: einen erfindungsgemäßen MEMS-Sensor;
- Fig. 2: zeigt: Verfahrensschritte zur Herstellung des MEMS-Sensors von Fig. 1; und
- Fig. 3: zeigt: eine vergrößerte Darstellung zu den Verfahrensschritten e) und f) von Fig. 2.

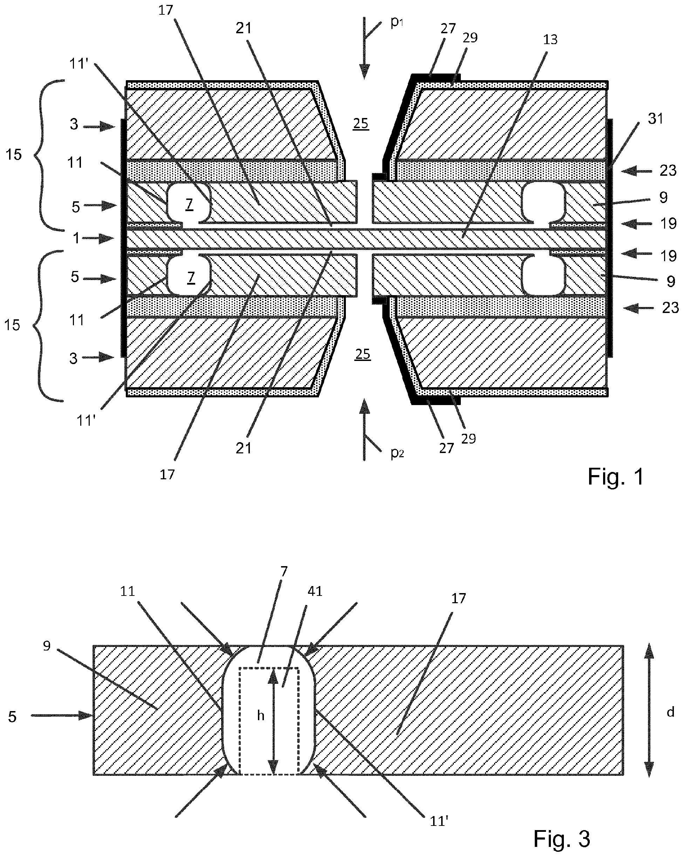

Fig. 1 zeigt ein Ausführungsbeispiel eines erfindungsgemäßen MEMS-Sensors. Um dabei auch Komponenten mit zum Teil sehr unterschiedlicher Baugröße erkennbar zu machen, wurde hier eine nicht maßstabsgetreue Darstellung gewählt. Bei dem dargestellten Ausführungsbeispiel handelt es sich um einen Differenzdrucksensor. Die Erfindung ist jedoch nicht auf Drucksensoren beschränkt, sondern kann genauso auch bei anderen MEMS-Sensoren zur messtechnischen Erfassung einer Messgröße eingesetzt werden, die mehrere aufeinander angeordnete Lagen 1, 3, 5, insb. Siliziumlagen, umfassen, von denen mindestens eine eine innere Lage 5 ist, die zwischen einer ersten Lage 1 und einer zweiten Lage 3 angeordnet ist, und in der mindestens eine senkrecht zur Ebene der inneren Lage 5 durch die innere Lage 5 hindurch verlaufende Ausnehmung 7 vorgesehen ist, an die außenseitlich zumindest abschnittweise ein ein Verbindungselement 9 bildender Bereich der inneren Lage 5 angrenzt, der mit der ersten Lage 1 und der zweiten Lage 3 verbundenen ist.

Erfindungsgemäß wird die Überlastfestigkeit dieser MEMS-Sensoren dadurch erhöht, dass eine die Ausnehmung 7 außenseitlich zumindest abschnittweise begrenzende Mantelfläche 11 des Verbindungselement 9 in einem der erste Lage 1 zugewandten Endbereich eine die Querschnittsfläche der Ausnehmung 7 in Richtung der ersten Lage 1 verkleinernde, abgerundete Formgebung aufweist, und in einem der zweiten Lage 3 zugewandten Endbereich eine die Querschnittsfläche der Ausnehmung 7 in Richtung der zweiten Lage 3 verkleinernde, abgerundete Formgebung aufweist. Durch diese endseitig vorgesehenen Abrundungen entsteht ein weicher Übergang vom Verbindungselement 9 zur ersten Lage 1 und vom Verbindungselement 9 zur zweiten Lage 3. Hierdurch werden Spannungskonzentrationen deutlich reduziert, so dass die erfindungsgemäßen MEMS-Sensoren deutliche höheren Belastungen standhalten können. Sie weisen somit eine höhere Überlastfestigkeit auf.

Umfasst mindestens eine innere Lage 5 des MEMS-Sensors mindestens einen weiteren mit der daran angrenzenden ersten Lage 1 oder der daran angrenzenden zweiten Lage 3 verbundenen Bereich, der an eine senkrecht zu dieser inneren Lage 5 durch diese innere Lage 5 hindurch verlaufende Ausnehmungen 7 angrenzt, so weist auch eine diese Ausnehmung 7 zumindest abschnittweise außenseitlich begrenzende Mantelfläche 11' dieses weiteren Bereichs vorzugweise in deren der mit dem weiteren Bereich verbundenen Lage 1, 3 zugewandten Endbereich eine die Querschnittsfläche der Ausnehmung 7 in Richtung der mit dem weiteren Bereich verbundenen Lage 1,3 verkleinernde, abgerundete Formgebung auf.

Spannungskonzentrationen werden umso stärker reduziert, je größer ein Krümmungsradius ist, den die abgerundeten Endbereiche aufweisen. Dabei können umso größere Krümmungsradien eingesetzt werden, je größer die Schichtdicke der inneren Lage 5 ist und je mehr Platz für die Ausnehmung 7 zur Verfügung steht. Die Endbereiche weisen je nach Schichtdicke und Platzangebot vorzugsweise jeweils einen Krümmungsradius von größer gleich 1 µm, vorzugsweise größer gleich
5 µm, und besonders bevorzugt von größer gleich 10 µm auf.

Die erste Lage 1 des in Fig. 1 dargestellten Differenzdrucksensors umfasst einen als Messmembran 13 dienenden Bereich. Die erste Lage 1 ist zwischen zwei Grundkörpern 15 angeordnet und mit jedem der beiden Grundkörper 15 jeweils unter Einschluss einer Druckkammer verbunden.

Jeder Grundkörper 15 umfasst jeweils eine inneren Lage 5 und eine zweite Lage 3. In den inneren Lagen 5 der Grundkörper 15 ist jeweils eine durch die jeweilige innere Lage 5 hindurch verlaufende Ausnehmung 7 vorgesehen. Die Ausnehmungen 7 bilden hier jeweils zu einem Ring geschlossene Isolationsgräben, die die jeweilige innere Lage 5 in einen vom Isolationsgraben umgegebenen, eine Elektrode 17 bildenden Bereich und einen die Ausnehmung 7 außenseitlich allseitig umgebenden, äußeren Bereich unterteilen. In dem hier gezeigten Ausführungsbeispiel weist jeder Grundkörper 15 nur eine Elektrode 17 auf. Es ist aber ohne weiteres möglich Grundkörper 15 mit zwei oder mehr Elektroden auszustatten, z.B. in dem in der inneren Lage 5 zusätzliche Isolationsgräben vorgesehen werden, durch die der vom äußeren Bereich der inneren Lage 5 umschlossene Bereich in entsprechend viele jeweils als Elektrode nutzbare Teilbereiche unterteilt wird.

Die äußeren Bereiche bilden jeweils ein zwischen der ersten Lage 1 und der zweiten Lage 3 angeordnetes mit der ersten Lage 1 und der zweiten Lage 3 verbundenes Verbindungselement 9. Erfindungsgemäß weisen die Verbindungselemente 9 jeweils eine die jeweilige Ausnehmung 7 außenseitlich begrenzende Mantelfläche 11 auf, die in einem der erste Lage 1 zugewandten Endbereich eine die Querschnittsfläche der Ausnehmung 7 in Richtung der ersten Lage 1 verkleinernde, abgerundete Formgebung aufweist, und die in einem der zweiten Lage 3 zugewandten Endbereich eine die Querschnittsfläche der Ausnehmung 7 in Richtung der zweiten Lage 3 verkleinernde, abgerundete Formgebung aufweist.

Bei erfindungsgemäßen MEMS-Sensoren können die einzelnen Lagen 1,3 5 je nach Art des Sensors und Funktion der einzelnen Lagen 1, 3, 5 jeweils entweder unmittelbar oder über eine zwischen zwei benachbarte Lagen vorgesehene Verbindungsschicht 19, 23, z.B. eine Isolationsschicht, z.B. aus Siliziumdioxid, miteinander verbunden sein. Die Verbindungsschichten 19, 23 weisen eine im Vergleich zur Schichtdicke der Lagen 1, 3, 5 geringe Schichtdicke auf.

So weisen die Lagen 1, 3, 5 je nach Funktion regelmäßig Schichtdicken größer gleich einem oder mehreren 10 µm, häufig sogar in der Größenordnung von einem oder mehreren 100 µm, z.B. von 100 µm bis 400 µm, auf. Bei dem in Fig. 1 dargestellten Differenzdrucksensor weisen die als Stützlagen dienenden zweiten Lagen 3 vorzugsweise Schichtdicken in der Größenordnung von einem oder mehreren 100 µm, z.B. 200 µm, auf. Demgegenüber können die inneren Lagen 5 geringere Schichtdicken, z.B. Schichtdicken in der Größenordnung von 40 µm bis 50 µm aufweisen. Die die Messmembran 13 umfassende erste Lage 1 weist eine in Abhängigkeit vom Messbereich des Drucksensors vorgegebene Schichtdicke auf, die je nach Messbereich z.B. in der Größenordnung von einem oder mehreren 10 µm liegt. Demgegenüber weisen die Verbindungsschichten 19, 23 vorzugsweise eine Schichtdicke in der Größenordnung von einem oder mehreren Mikrometern, z.B. von 1 µm bis 5 µm, insb. 2 µm bis 4 µm, auf.

In dem dargestellten Ausführungsbeispiel sind die inneren Lagen 5 der beiden Grundkörper 15 mit der ersten Lage 1 jeweils über eine erste Verbindungsschicht 19, vorzugsweise eine Isolationsschicht, z.B. aus Siliziumdioxid, verbunden. Die ersten Verbindungsschichten 19 weisen jeweils eine, hier als Druckkammer genutzte Aussparung 21 auf, die den gesamten als Messmembran 13 dienenden Bereich der ersten Lage 1 frei gibt. Die Aussparungen 21 sind derart bemessen, dass die Ausnehmungen 7 in den inneren Schichten 5 jeweils in der daran angrenzenden Aussparung 21 münden. Aufgrund der Aussparungen 21 sind die in den Grundkörpern 15 integrierten Elektroden 17 von der Messmembran 13 beabstandet und die Messmembran 13 ist in beide Richtungen senkrecht zur ersten Lage 1 auslenkbar. Hierzu ist je nach Druckmessbereich und Dicke der Messmembran 13 eine Schichtdicke der ersten Verbindungsschichten 19 von einem oder wenigen Mikrometern, z.B. 2 µm, ausreichend. Diese Ausführungsform bietet den Vorteil, dass die Schichtdicke der ersten Verbindungsschichten 19 und damit auch der hierdurch gegebene Elektrodenabstand zwischen der jeweiligen Elektrode 17 und der als Gegenelektrode dienenden ersten Lage 1 extrem präzise vorgegeben werden kann.

Ein Abstand zwischen Elektrode 17 und Messmembran 13 kann alternativ auch ohne den Einsatz einer ersten Verbindungsschicht 19 erzielt werden, indem die mit den zweiten Lagen 3 verbundenen Elektroden 17 jeweils eine Schichtdicke aufweisen, die geringer als die Schichtdicke der Verbindungselemente 9 ist. Diese Variante ist bei dem in der DE 103 93 943 B3 beschriebenen Drucksensor vorgesehen.

Jede der Elektroden 17 bildet einen an die Ausnehmung 7 im jeweiligen Grundkörper 15 angrenzenden weiteren Bereich der inneren Lage 5, der eine die Ausnehmung 7 zumindest abschnittweise außenseitlich begrenzende Mantelfläche 11' aufweist. Entsprechend weisen auch die die Ausnehmung 7 begrenzenden Mantelflächen 11' der Elektroden 17 vorzugsweise zumindest in deren, der jeweils damit verbundenen zweiten Lage 3 zugewandten Endbereich eine die Querschnittsfläche der Ausnehmung 7 in Richtung der zweiten Lage 3 verkleinernde, abgerundete Formgebung auf.

Zur elektrischen Isolation der Elektroden 17 gegenüber der zweiten Lage 3 des jeweiligen Grundkörpers 15 sind die inneren Lagen 5 jeweils über eine als Isolationsschicht ausgebildete zweite Verbindungschicht 23, z.B. aus Siliziumdioxid, mit der jeweils daran angrenzenden zweiten Lage 3 verbunden. Zur Reduktion parasitärer Kapazitäten weisen die zweiten Verbindungsschichten 23 vorzugsweise eine Schichtdicke von mehreren Mikrometern, z.B. in der Größenordnung von 4 µm, auf.

Beide Grundkörper 15 weisen jeweils eine durch den Grundkörper 15 hindurch verlaufende Ausnehmung 25 auf, die von außen durch die zweite Lage 3, die zweite Verbindungsschicht 23 und die Elektrode 17 hindurch verläuft, und in der die Messmembran 13 frei gebenden Aussparung 21 in der ersten Verbindungsschicht 19 mündet. Im Messbetrieb wird die dem einen Grundkörper 15 zugewandte Seite der Messmembran 13 über dessen Ausnehmung 25 mit einem ersten Druck p₁, und die dem anderen Grundkörper 15 zugewandte Seite der Messmembran 13 über dessen Ausnehmung 25 mit einem zweiten Druck p₂ beaufschlagt. Dies führt zu einer vom auf die Messmembran 13 einwirkenden Differenzdruck Δp abhängigen Durchbiegung der Messmembran 13.

Jede der beiden Elektroden 17 bildet zusammen mit der als Gegenelektrode dienenden ersten Lage 1 einen Kondensator mit einer von der druckabhängigen Durchbiegung der Messmembran 13 abhängigen Kapazität. Zur messtechnischen Erfassung des zu messenden Differenzdruck Δp wird mindestens eine der beiden Kapazitäten mittels einer hier nicht dargestellten, daran angeschlossenen Messschaltung erfasst und in ein vom Differenzdruck Δp abhängiges Signal umgewandelt, das dann zur Anzeige und/oder zur weiteren Auswertung und/oder Verarbeitung zur Verfügung steht.

Der elektrische Anschluss der Elektroden 17 erfolgt z.B. über einen auf dem jeweiligen Grundkörper 15 vorgesehenen Elektrodenanschluss 27, der sich von einem über die Ausnehmung 25 im jeweiligen Grundkörper 15 frei gelegten Bereich der von der Messmembran 13 abgewandten Seite der Elektrode 17 entlang einer Mantelfläche der Ausnehmung 25 bis zu einem auf einer von der Messmembran 13 abgewandten Seite der jeweiligen zweiten Lage 3 vorgesehenen Anschlussbereich erstreckt. Vorzugsweise sind die Elektrodenanschlüsse 27 gegenüber der zweiten Lage 3 des jeweiligen Grundkörpers 15 elektrisch isoliert, z.B. indem zwischen den Mantelflächen der zweiten Lagen 3, über die die Elektrodenanschlüsse 27 verlaufen, und dem jeweiligen Elektrodenanschluss 27 jeweils eine Isolationsschicht 29 vorgesehen wird.

Der elektrische Anschluss der Messmembran 13 kann z.B. über einen auf der äußeren Mantelfläche des MEMS-Sensors z.B. als Metallisierung aufgebrachten Membrananschluss 31 erfolgen, wie er z.B. in der DE 103 93 943 B3 beschrieben ist. Andere dem Fachmann bekannte Membrananschlussformen sind natürlich ebenfalls einsetzbar. So kann z.B. zumindest einer der beiden Grundkörper 15 mit einem hier nicht dargestellten Membrananschluss ausgestattet werden, der entlang einer Mantelfläche einer am äußeren Rand des Grundkörpers 15 vorgesehenen Ausnehmung bis zu einem durch die Ausnehmung frei gelegten Randbereich der ersten Lage 1 verläuft, wo er elektrisch leitend mit dem frei gelegten Randbereich der ersten Lage 1 verbunden ist.

Wird der Differenzdrucksensor einer einseitigen Druckbelastung ausgesetzt, bei der die Messmembran 13 in der Darstellung von Fig. 1 nach oben ausgelenkt wird, so treten die größten Belastungen im Übergangsbereich vom Verbindungselement 9 des unteren Grundkörpers 15 zur ersten Lage 1 auf. Bei einer einseitigen Druckbelastung, bei der die Messmembran 13 in der Darstellung von Fig. 1 nach unten ausgelenkt wird, treten die größten Belastungen im Übergangsbereich vom Verbindungselement 9 des oberen Grundkörpers 15 zur ersten Lage 1 auf. In beiden Fällen wirken die an den entsprechenden Übergangsbereichen vorgesehenen abgerundeten Endbereiche der Mantelflächen 11 der Verbindungselemente 9 Spannungskonzentrationen entgegen, so dass die Übergangsbereiche nur deutlich geringeren und gleichmäßiger über den jeweiligen Übergangsbereich verteilten Belastung ausgesetzt sind. Der gleiche gilt natürlich analog auch bei einer beidseitigen Belastung, wie sie z.B. dann auftritt, wenn die Messmembran 13 einem einem sehr hohen Systemdruck überlagerten Differenzdruck Δp ausgesetzt ist. Bei einer solchen beidseitigen Belastung treten die größten Spannungen im Übergangsbereich vom Verbindungselement 9 des oberen Grundkörpers 15 zur zweiten Lage 3 des oberen Grundkörpers 15 und im Übergangsbereich vom Verbindungselement 9 des unteren Grundkörpers 15 zur zweiten Lage 3 des unteren Grundkörpers 15 auf. Dabei wirken die an den entsprechenden Übergangsbereichen vorgesehenen abgerundeten Endbereiche der Mantelflächen 11 der Verbindungselemente 9 auch hier Spannungskonzentrationen entgegen. Erfindungsgemäße Sensoren weisen somit eine höhere Überlastfestigkeit auf.

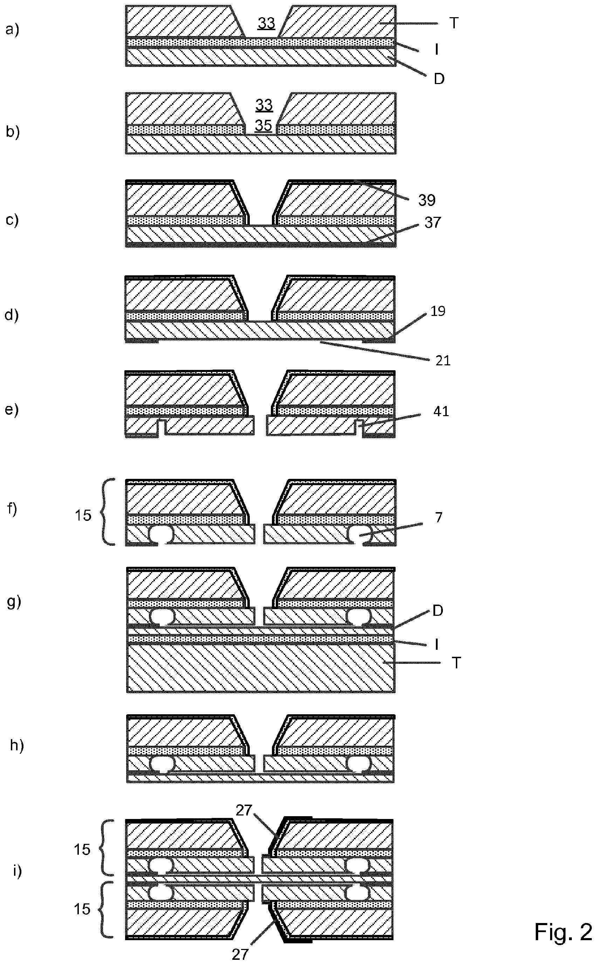

Weiter umfasst die Erfindung ein im Waferverband ausführbares Verfahren zur Herstellung erfindungsgemäßer MEMS-Sensoren, das nachfolgend am Beispiel des in Fig. 1 dargestellten Differenzdrucksensors erläutert ist. Fig. 2 zeigt hierzu die einzelnen in den Verfahrensschritten a) -i) erzeugten Zwischenprodukte. Zur Herstellung der Sensoren werden vorzugsweise 3 SOI-Wafer verwendet, die jeweils eine elektrisch leitfähige Trägerschicht T aus Silizium, eine darauf angeordnete Isolationsschicht I aus Siliziumdioxid, und eine auf der Isolationsschicht I angeordnete elektrisch leitfähige Deckschicht D aus Silizium aufweisen. Dabei wird aus einem ersten SOI-Wafer im Waferverband ein erster Satz Grundkörper 15 erzeugt, wobei aus der Trägerschicht T die zweiten Lagen 3, aus der Deckschicht D die inneren Lagen 5, und aus dessen Isolationsschicht I die zweiten Verbindungsschichten 23 gefertigt werden.

In Verfahrensschritt a) werden in der Trägerschicht T die durch die zweiten Lagen 3 verlaufenden Teilbereiche 33 der Ausnehmungen 25 der Grundkörper 15 erzeugt. Hierzu können in einem z.B. mit Kaliumhydroxid (KOH) ausgeführten Ätzverfahren an den entsprechenden Stellen die Teilbereiche 33 bildende Gruben in die Trägerschicht T geätzt werden. Im darauf folgenden Verfahrensschritt b) werden in der Isolationsschicht I die durch die zweiten Verbindungsschichten 23 verlaufenden Teilbereiche 35 der Ausnehmungen 25 der Grundkörper 15 erzeugt. Hierzu wird ein zur selektiven Entfernung von Siliziumoxid geeignetes Ätzverfahren, wie z. B. das Reaktive Ionen Ätzen (RIE), verwendet.

Im nachfolgenden Verfahrensschritt c) wird auf der Ober- und der Unterseite des Wafers unter Aussparung der für die elektrisch leitfähigen Verbindungen der Elektrodenanschlüsse 27 zur jeweiligen Elektrode 17 benötigten Oberflächen jeweils eine Isolationsschicht 37, 39 erzeugt.

Hierzu kann zum Beispiel ein Feuchtoxidationsverfahren eingesetzt werden, mit dem eine Siliziumoxidschicht auf die entsprechenden Oberflächen aufgebracht wird.

Nachfolgend werden in Verfahrensschritt d) aus der auf die Deckschicht D aufgebrachten Isolationsschicht 37 die ersten Verbindungsschichten 19 gefertigt, indem in der Isolationsschicht 37 die Aussparungen 21 erzeugt werden. Hierzu kann zum Beispiel ein Trockenätzverfahren eingesetzt werden.

Im Anschluss daran werden die Ausnehmungen 7 in den inneren Lagen 5 erzeugt. Dabei wird zur Erzeugung der die Ausnehmung 7 außenseitlich begrenzenden Mantelflächen 11, 11' mit endseitig abgerundeter Formgebung vorzugsweise eine Kombination aus einem anisotropen Ätzverfahren und einem isotropen Ätzverfahren verwendet.

Hierzu wird vorzugsweise derart verfahren, dass in einem ersten Verfahrensschritt e) mittels eines anisotropen Ätzverfahrens Gräben 41 in der die inneren Lagen 5 bildenden Deckschicht D erzeugt werden. Die Gräben 41 erstrecken sich bis zu einer vorgegebenen Ätztiefe h im Wesentlichen senkrecht zur Ebene der Deckschicht D in die Deckschicht D hinein, durchdringen diese aber nicht. Hierzu kann ein anisotropes Ätzverfahren, z.B. ein reaktives lonentiefenätzverfahren (DRIE), eingesetzt werden, bei dem zwischen aufeinanderfolgenden Ätzschritten jeweils eine Passivierungsschicht, z.B. eine Polymerschicht, z.B. aus Octafluocyclobutan (C₄F₈), auf die Innenflächen der bis dahin eingeätzten Grabensegmente aufgebracht wird. Die Ätzschritte werden z.B. mittels eines energiereichen Hochfrequenzplasmas ausgeführt, das z.B. aus in ein Trägergas, z.B. Argon, eingebrachtem Schwefelhexafluorid (SF₆) erzeugt wird. Während der Ätzung findet eine chemische Ätzreaktion durch Schwefelhexafluorid-Radikale (SF₆) statt, der ein physikalischer Materialabtrag durch in einem elektrischen Feld beschleunigte Argon-Ionen überlagert ist. Während die chemische Ätzreaktion im Wesentlichen isotrop ist, weist der physikalische Materialabtrag eine von der lonen-Beschussrichtung und der Ionen-Energie abhängige Anisotropie auf. Die Richtungsabhängigkeit des physikalischen Materialabtrags hat zur Folge, dass die zwischen den Ätzschritten aufgebrachten Passivierungsschichten an den Böden der Grabensegmente schneller abgetragen werden, als an deren Seitenwänden, so dass die Seitenwände vor weiterem Materialabtrag durch den chemischen Ätzprozess geschützt sind. Durch die alternierende Abfolge von Ätz- und Passivierungsschritten entstehen Gräben 41 mit im Wesentlichen senkrecht zur inneren Lage 5 verlaufenden Seitenwänden. Fig. 3 zeigt hierzu eine vergrößerte Darstellung der Ausnehmung 7 in der inneren Lage 5, in der ein in Verfahrensschritt e) erzeugter im Querschnitt rechteckförmige Graben 41 gestrichelt dargestellt ist.

Im Anschluss an die anisotrope Ätzung der Gräben 41 werden die Passivierungsschichten entfernt, und die Ausnehmungen 7 in Verfahrensschritt f) vervollständigt. Hierzu wird ein isotropes Ätzverfahren, wie z.B. das Reaktive lonenätzen (RIE) eingesetzt. Letzteres unterscheidet sich von dem in Verfahrensschritt e) beschriebenen Reaktiven lonentiefenätzen (DRIE) im Wesentlichen dadurch, dass keine Passivierungsschichten aufgebracht werden, und der physikalische Materialabtrag möglichst gering gehalten wird, so dass die isotrope chemische Reaktion den Ätzprozess dominiert.

Durch das isotrope Ätzverfahrens werden die Gräben 41 in alle Richtungen vergrößert, wodurch die die resultierenden Ausnehmungen 7 außenseitlich begrenzenden Mantelflächen 11, 11' des Verbindungselements 9 und der Elektrode 17 in deren der ersten Lage 1 zugewandten Endbereich und in deren der zweiten Lage 3 zugewandten Endbereich die in Fig. 3 durch darauf ausgerichtete Pfeile hervorgehobene abgerundete Formgebung erhalten. Dabei kann der Krümmungsradius der abgerundeten Endbereiche über eine in Relation zur Schichtdicke d der inneren Lage 5 getroffene Vorgabe der Ätztiefe h, bis zu der die Gräben 41 in die innere Lage 5 eingeätzt werden, innerhalb gewisser Grenzen vorgegeben werden. Hierzu wird die anisotrope Ätzung bis zu einer Ätztiefe h ausgeführt, bei der die Differenz zwischen der Schichtdicke d der inneren Lage 5 und der Ätztiefe h dem zu erzeugenden Krümmungsradius entspricht.

Nachfolgend wird in Verfahrensschritt g) ein zweiter SOl Wafer mit dem gemäß den Verfahrensschritten a) - f) bearbeiteten ersten Wafer derart, z.B. durch Bonden, verbunden, dass die Deckschicht D des zweiten Wafers auf den aus der Deckschicht D des ersten Wafers erzeugten ersten Verbindungsschichten 19 aufliegt. Anschließend werden in Verfahrensschritt h) die Trägerschicht T und die Isolationsschicht l des zweiten SOl Wafers entfernt. Zum Entfernen der Trägerschicht T eignen sich Ätzverfahren, wie z.B. das Reaktive lonenätzen (RIE). Zum Entfernen der Isolationsschicht l eignen sich zum Beispiel nasschemische Ätzverfahren, wie z.B. mit Flusssäure (HF) ausgeführte Ätzverfahren. Die verbleibende Deckschicht D des zweiten Wafers bildet die, die Messmembranen 13 umfassenden ersten Lagen 1 der Differenzdrucksensoren.

Parallel zur Ausführung der Verfahrensschritte a)-f) oder im Anschluss daran wird aus einem dritten SOl Wafer ein weiterer Satz Grundkörper 15 gefertigt. Hierzu kann das oben beschriebene Verfahren eingesetzt werden.

Im Anschluss werden in Verfahrensschritt i) die aus dem dritten Wafer erzeugten Grundkörper 15 im Waferverband derart mit dem am Ende von Verfahrensschritt h) zur Verfügung stehenden Verbund z.B. durch Bonden verbunden, dass sich die Grundkörper 15, 15 zu beiden Seiten der Messmembranen 13 paarweise gegenüberliegen. Zusätzlich werden die Elektrodenanschlüsse 27 auf die entsprechenden Mantelflächen aufgebracht, z.B. als metallische Beschichtung aufgesputtert. Im Anschluss werden die auf diese Weise hergestellten Differenzdrucksensoren durch Sägen entlang der äußeren Mantelflächen der einzelnen Differenzdrucksensoren vereinzelt, und die Membrananschlüsse 31 aufgebracht, z.B. als metallische Beschichtung aufgesputtert.

Die Erfindung kann völlig analog in Verbindung mit Abwandlungen der hier dargestellten Drucksensoren eingesetzt werden. Als Beispiel seien Differenzdrucksensoren genannt, die sich von dem hier dargestellten Ausführungsbeispiel dadurch unterscheiden, dass nur einer der beiden Grundkörper eine Elektrode aufweist, dass mindestens einer der beiden Grundkörper zwei oder mehr Elektroden aufweist, oder dass die Ausnehmung eine Druckkammer umfasst, deren Höhe kleiner gleich oder sogar gleich der Schichtdicke der inneren Lage ist. Ein weiteres Beispiel sind Relativdrucksensoren, die nur einen Grundkörper aufweisen, der unter Einschluss einer Druckammer mit einer die Messmembran umfassenden ersten Lage verbunden ist. In dem Fall entfällt der in den beschriebenen Differenzdrucksensoren vorgesehene zweite Grundkörper 15. Bei Relativdrucksensoren wird die Außenseite der Messmembran 13 mit dem zu messenden Druck p beaufschlagt, während an deren Innenseite ein der Druckkammer über die Ausnehmung 25 im Grundkörper 15 zugeführter Referenzdruck anliegt. Völlig analog zu diesen Relativdrucksensoren können natürlich auch Absolutdrucksensoren aufgebaut werden, indem die Druckkammer der beschriebenen Relativdrucksensoren evakuiert wird. In dem Fall entfällt die durch den Grundkörper 15 hindurch führende, in der Druckkammer mündende Ausnehmung, wobei die im Grundkörper integrierte Elektrode z.B. durch eine deren von der Messmembran abgewandte Elektrodenrückseite frei gebende Ausnehmung im Grundkörpers hindurch elektrisch kontaktiert werden kann.

Darüber hinaus kann die Erfindung natürlich völlig analog auch in anderen MEMS-Sensoren zur messtechnischen Erfassung von Drücken oder anderen Messgrößen eingesetzt werden, die mindestens eine zwischen einer ersten und einer zweiten Lage angeordnete innere Lage aufweisen, durch die mindestens eine Ausnehmung hindurch verläuft, die außenseitlich zumindest abschnittweise von mindestens einem mit der ersten und der zweiten Lage verbundenen Verbindungselement begrenzt wird.

## Patentansprüche

1. MEMS-Sensor zur messtechnischen Erfassung einer Messgröße,
- der mehrere aufeinander angeordnete Lagen (1, 3, 5), insb. Siliziumlagen, umfasst,
- dessen Lagen (1, 3, 5) mindestens eine innere Lage (5) umfassen, die zwischen einer ersten Lage (1) und einer zweiten Lage (3) angeordnet ist, und
- in dessen innere Lage (5) mindestens eine senkrecht zur Ebene der inneren Lage (5) durch die innere Lage (5) hindurch verlaufende ringförmige Ausnehmung (7) vorgesehen ist, an die außenseitlich ein ein Verbindungselement (9) bildender Bereich der inneren Lage (5) angrenzt, der mit der ersten Lage (1) und der zweiten Lage (3) verbundenen ist, und der die Ausnehmung (7) ringförmig umgibt, wobei die erste Lage (1) eine Messmembran (13) umfasst, und die erste Lage (1) unter Einschluss einer Druckkammer mit einem Grundkörper (15) verbunden ist, der die innere Lage (5) und die zweite Lage (3) umfasst, wobei der MEMS-Sensor ein Drucksensor, insb. ein Absolutdruck-, ein Relativdruck- oder ein Differenzdrucksensor ist, wobei
eine die Ausnehmung (7) außenseitlich begrenzende Mantelfläche (11) des Verbindungselements (9)
- in einem der erste Lage (1) zugewandten Endbereich eine die Querschnittsfläche der Ausnehmung (7) in Richtung der ersten Lage (1) verkleinernde, abgerundete Formgebung aufweist, und
- in einem der zweiten Lage (3) zugewandten Endbereich eine die Querschnittsfläche der Ausnehmung (7) in Richtung der zweiten Lage (3) verkleinernde, abgerundete Formgebung aufweist,
**dadurch gekennzeichnet, dass**
zueinander benachbarte Lagen (1,3 5) jeweils über eine zwischen den beiden benachbarten Lagen (1, 3 , 5) vorgesehene Isolationsschicht (19, 23), insb. aus Siliziumdioxid, miteinander verbunden sind, wobei
das Verbindungselement (9) im Bereich der inneren Lage (5) durch die Ausnehmung (7) vollständig von einem von der Ausnehmung (7) umgebenen, als Elektrode dienenden weiteren Bereich (17) getrennt ist.

2. MEMS-Sensor gemäß Anspruch 1, **dadurch gekennzeichnet, dass**
- mindestens eine innere Lage (5) mindestens einen von der Ausnehmung (7) umgebenen, weiteren Bereich aufweist, der mit der ersten Lage (1) oder der zweiten Lage (3) verbunden ist, der an eine senkrecht zur inneren Lage (5) durch die innere Lagen (5) hindurch verlaufende Ausnehmungen (7) angrenzt, und
- eine die Ausnehmung (7) zumindest abschnittweise außenseitlich begrenzende Mantelfläche (11') des weiteren Bereichs in deren, der mit dem weiteren Bereich verbundenen Lage (1, 3) zugewandten Endbereich eine die Querschnittsfläche der Ausnehmung (7) in Richtung der mit dem weiteren Bereich verbundenen Lage (1,3) verkleinernde, abgerundete Formgebung aufweist.

3. MEMS-Sensor gemäß Anspruch 2, **dadurch gekennzeichnet, dass**
- die Verbindungsschichten (19, 23) eine im Vergleich zur Schichtdicke der Lagen (1, 3, 5) geringe Schichtdicke, insb. eine Schichtdicke in der Größenordnung von einem oder mehreren Mikrometern, insb. ein Schichtdicke von 1 µm bis 5 µm, insb. 2 µm bis 4 µm, aufweisen,
- wobei die Lagen (1, 3, 5) insb. eine Schichtdicke von größer gleich mehreren 10 µm aufweisen,

4. MEMS-Sensor gemäß Anspruch 1, **dadurch gekennzeichnet, dass** das Verbindungselement (9) die Ausnehmung (7) außenseitlich allseitig umgibt.

5. MEMS-Sensor gemäß Anspruch 1, **dadurch gekennzeichnet, dass** die innere Lage (5) mindestens einen weiteren Bereich, insb. einen als Elektrode (17) dienenden weiteren Bereich, insb. einen von einem Isolationsgraben, insb. einem durch die Ausnehmung (7) gebildete Isolationsgraben, umgebenen weiteren Bereich umfasst.

6. MEMS-Sensor gemäß Anspruch 1, **dadurch gekennzeichnet, dass**
- die innere Lage (5) über eine erste Verbindungsschicht (19) mit der ersten Lage (1) verbunden ist, und
- die erste Verbindungschicht (19) eine die Messmembran (13) frei gebende, eine Druckkammer bildende Aussparung (21) aufweist.

7. MEMS-Sensor gemäß Anspruch 1 oder 6, **dadurch gekennzeichnet, dass**
- die innere Lage (5) mindestens einen als Elektrode (17) dienenden weiteren Bereich, insb. einen von einem Isolationsgraben, insb. einem durch die Ausnehmung (7) gebildeten Isolationsgraben, umgebenen weiteren Bereich umfasst,
- die innere Lage (5) über eine als Isolationsschicht ausgebildete zweite Verbindungsschicht (23) mit der zweiten Lage (3) verbunden ist,
- die Elektrode (17) über die zweite Verbindungsschicht (23) mit der zweiten Lage (3) verbunden ist, und
- die Elektrode (17) von der als Gegenelektrode hierzu dienenden ersten Lage (1) beabstandet ist.

8. MEMS-Sensor gemäß Anspruch 1, **dadurch gekennzeichnet, dass**
der Grundkörper (15) eine durch den Grundkörper (15) hindurch verlaufende Ausnehmung (25) aufweist, die in der Druckkammer mündet.

9. MEMS-Sensor gemäß Anspruch 1 und 8, **dadurch gekennzeichnet, dass** auf einer dem Grundkörper (15) gegenüberliegenden Seite der ersten Lage (1) ein weiterer Grundkörper (15), insb. ein baugleicher weiterer Grundkörper (15) vorgesehen ist, der unter Einschluss einer Druckkammer mit der ersten Lage (1) verbunden ist.

10. MEMS-Sensor gemäß Anspruch 1 -9, **dadurch gekennzeichnet,**
**dass** die abgerundeten Endbereiche einen in Abhängigkeit von der Schichtdicke (d) der jeweiligen inneren Lage (5) ausgewählten Krümmungsradius aufweisen, der größer gleich 1 µm, insb. größer gleich 5 µm, insb. größer gleich 10 µm ist.

11. Verfahren zur Herstellung eines MEMS-Sensors gemäß einem der vorangehenden Ansprüche, **dadurch gekennzeichnet, dass** die Ausnehmung (7) durch eine Kombination aus einem anisotropen Ätzverfahren und einem isotropen Ätzverfahren erzeugt wird.

12. Verfahren gemäß Anspruch 11, **dadurch gekennzeichnet, dass**
- mittels eines anisotropen Ätzverfahrens, insb. mittels Reaktivem lonentiefenätzen (DRIE), ein Graben (41), insb. ein Graben (41) mit im Wesentlichen senkrecht zur inneren Lage (5) verlaufenden Seitenwänden, in der inneren Lage (5) erzeugt wird, der sich bis zu einer vorgegebenen Ätztiefe (h) in die innere Lage (5) hinein erstreckt, diese aber nicht vollständig durchdringt, und
- mittels eines isotropen Ätzverfahrens, insb. mittels Reaktivem lonenätzen (RIE), aus dem Graben (41) die durch die innere Lage (5) hindurch verlaufende Ausnehmung (7) erzeugt wird.

13. Verfahren gemäß Anspruch 12, **dadurch gekennzeichnet, dass**
die Ätztiefe (h) in Abhängigkeit von einer Schichtdicke (d) der inneren Lage (5) derart vorgegeben wird, dass eine Differenz zwischen der Schichtdicke (d) der inneren Lage (5) und der Ätztiefe (h) einem zu erzeugenden Krümmungsradius der abgerundeten Endbereicheentspricht.

## Claims

1. MEMS sensor designed to record a measured variable,
- wherein said sensor comprises multiple layers (1, 3, 5), particularly silicon layers, arranged on top of one another,
- wherein the layers (1, 3, 5) comprise at least an inner layer (5), which is arranged between a first layer (1) and a second layer (3), and
- wherein, in the inner layer (5), at least an annular recess (7) is provided which extends perpendicularly to the plane of the inner layer (5) and through the inner layer (5), wherein an area of the inner layer (5) which forms a connection element (9) is adjacent to the outside of said recess, wherein said area is connected to the first layer (1) and to the second layer (3) and surrounds the recess (7) in an annular manner, wherein the first layer (1) comprises a measuring membrane (13), and wherein - with the inclusion of a pressure chamber - the first layer (1) is connected to a meter body (15) which comprises the inner layer (5) and the second layer (3), wherein the MEMS sensor is a pressure sensor, particularly an absolute pressure sensor, a relative pressure sensor or a differential pressure sensor, wherein a lateral surface (11) of the connection element (9), delimiting the recess (7) on the outside, has
- a rounded shape in an end section facing towards the first layer (1) which reduces the cross-sectional area of the recess (7) in the direction of the first layer (1), and
- a rounded shape in an end section facing towards the second layer (3) which reduces the cross-sectional area of the recess (7) in the direction of the second layer (3),
**characterized in that**
neighboring layers (1, 3, 5) are interconnected by means of an insulation layer (19, 23), particularly made of silicon dioxide, provided between the two adjacent layers (1, 3, 5), wherein, in the area of the inner layer (5), the connection element (9) is completely separated by the recess (7) from an additional area (17) that is surrounded by the recess (7) and serves as an electrode.

2. MEMS sensor as claimed in Claim 1, **characterized in that**
- at least an inner layer (5) has at least an additional area surrounded by the recess (7) and connected to the first layer (1) or to the second layer (3), wherein said area is adjacent to a recess (7) that extends perpendicularly to the inner layer (5) through the interior layers (5), and
- a lateral surface (11') of the additional area, which delimits the recess (7) on the outside at least in sections, has a rounded shape in the end section facing towards the layer (1, 3) connected to additional area, wherein said shape reduces the cross-sectional area of the recess (7) in the direction of the layer (1, 3) connected to the additional area.

3. MEMS sensor as claimed in Claim 2, **characterized in that**
- the connection layers (19, 23) have a lower layer thickness compared to the thickness of the layers (1, 3, 5), particularly a layer thickness in the range of one or more micrometers, particularly a layer thickness of 1 µm to 5 µm, particularly 2 µm to 4 µm,
- wherein the layers (1, 3, 5) particularly have a layer thickness greater than or equal to several tens of µm.

4. MEMS sensor as claimed in Claim 1, **characterized in that** the connection element (9) surrounds the recess (7) on the outside on all sides.

5. MEMS sensor as claimed in Claim 1, **characterized in that** the inner layer (5) comprises at least an additional area, particularly an additional area serving as an electrode (17), particularly an additional area surrounded by an isolation trench, particularly an isolation trench formed by the recess (7).

6. MEMS sensor as claimed in Claim 1, **characterized in that**
- the inner layer (5) is connected to the first layer (1) by means of a first connection layer (19), and
- the first connection layer (19) has a recess (21) which frees the measuring membrane (13) and forms a pressure chamber.

7. MEMS sensor as claimed in Claim 1 or 6, **characterized in that**
- the inner layer (5) comprises at least an additional area serving as the electrode (17), particularly an additional area surrounded by an isolation trench, particularly an isolation trench formed by the recess (7),
- the inner layer (5) is connected to the second layer (3) by means of a second connection layer (23) in the form of an insulation layer, and
- the electrode (17) is connected to the second layer (3) by means of the second connection layer (23), and
- the electrode (17) is spaced at a distance from the first layer (1) serving as the electrode's counterelectrode.

8. MEMS sensor as claimed in Claim 1, **characterized in that** the meter body (15) comprises a recess (25) that extends through the meter body (15) and enters into the pressure chamber.

9. MEMS sensor as claimed in Claim 1 or 8, **characterized in that** another meter body (15), particularly another meter body (15) that is identical in design, is provided on a side of the first layer (1) that is opposite the meter body (15), wherein said meter body (15) is connected to the first layer (1) with the inclusion of a pressure chamber.

10. MEMS sensor as claimed in Claims 1 to 9, **characterized in that** the rounded end areas have a radius of curvature, selected depending on the layer thickness (d) of the respective inner layer (5), wherein said radius of curvature is greater than or equal to 1 µm, particularly greater than or equal to 5 µm, particularly greater than or equal to 10 µm.

11. Procedure for the fabrication of a MEMS sensor as claimed in one of the previous claims, **characterized in that** the recess (7) is created by a combination of an anisotropic etching process and an isotropic etching process.

12. Procedure as claimed in Claim 11, **characterized in that**
- a trench (41), particularly a trench (41) with side walls that are essentially perpendicular to the inner layer (5), is created in the inner layer (5) by means of an anisotropic etching process, particularly by means of deep reactive ion etching (DRIE), wherein said trench extends into the inner layer (5) as far as a predefined etching depth (h) but does not penetrate it completely, and
- the recess (7) that passes through the inner layer (5) is created from the trench (41) by means of an isotropic etching process, particularly by means of reactive ion etching (RIE).

13. Procedure as claimed in Claim 12, **characterized in that** the etching depth (h) is predefined depending on a layer thickness (d) of the inner layer (5) in such a way that a difference between the layer thickness (d) of the inner layer (5) and the etching depth (h) corresponds to a radius of curvature of the rounded end sections which is to be generated.

## Revendications

1. Capteur MEMS destiné à la détection d'une grandeur de mesure,
- lequel capteur comprend une pluralité de couches (1, 3, 5), notamment des couches de silicium, disposées les unes au-dessus des autres,
- capteur dont les couches (1, 3, 5) comprennent au moins une couche intérieure (5) qui est disposée entre une première couche (1) et une deuxième couche (3), et
- capteur dans la couche intérieure (5) duquel est prévu au moins un évidement annulaire (7) qui s'étend perpendiculairement au plan de la couche intérieure (5) à travers la couche intérieure (5), évidement auquel se raccorde extérieurement une zone de la couche intérieure (5) qui forme un élément de liaison (9) et est reliée à la première couche (1) et à la deuxième couche (3) et qui entoure de manière annulaire l'évidement (7), la première couche (1) comprenant une membrane de mesure (13), et la première couche (1) étant reliée, en incluant une chambre de pression, à un corps de base (15) qui comprend la couche intérieure (5) et la deuxième couche (3), le capteur MEMS étant un capteur de pression, notamment un capteur de pression absolue, un capteur de pression relative ou un capteur de pression différentielle, une surface extérieure (11) de l'élément de liaison (9), laquelle surface extérieure (11) délimite l'évidement (7), présentant
- dans une zone d'extrémité tournée vers la première couche (1), une forme arrondie qui réduit la surface de la section transversale de l'évidement (7) dans la direction de la première couche (1), et
- dans une zone d'extrémité tournée vers la deuxième couche (3), une forme arrondie qui réduit la surface de la section transversale de l'évidement (7) en direction de la deuxième couche (3),
**caractérisé en ce que**
les couches mutuellement adjacentes (1, 3, 5) sont reliées entre elles par l'intermédiaire d'une couche isolante (19, 23), notamment en dioxyde de silicium, prévue entre les deux couches adjacentes (1, 3, 5),
l'élément de liaison (9) étant complètement séparé dans la zone de la couche intérieure (5) par l'évidement (7) d'une autre zone (17) entourée par l'évidement (7) et servant d'électrode.

2. Capteur MEMS selon la revendication 1, **caractérisé en ce que**
- au moins une couche intérieure (5) présente au moins une autre zone entourée par l'évidement (7) et reliée à la première couche (1) ou à la deuxième couche (3), laquelle zone se raccorde à un évidement (7) s'étendant perpendiculairement à la couche intérieure (5) à travers les couches intérieures (5), et
- une surface extérieure (11') de l'autre zone, qui délimite extérieurement l'évidement (7) au moins par sections, présente, dans sa zone d'extrémité tournée vers la couche (1, 3) reliée à l'autre zone, une forme arrondie qui réduit la surface de la section transversale de l'évidement (7) en direction de la couche (1, 3) reliée à l'autre zone.

3. Capteur MEMS selon la revendication 2, **caractérisé en ce que**
- les couches de liaison (19, 23) présentent une épaisseur de couche faible par rapport à l'épaisseur des couches (1, 3, 5), notamment une épaisseur de couche de l'ordre d'un ou plusieurs micromètres, notamment une épaisseur de couche de 1 µm à 5 µm, notamment de 2 µm à 4 µm,
- les couches (1, 3, 5) présentent notamment une épaisseur de couche supérieure ou égale à plusieurs dizaines de µm.

4. Capteur MEMS selon la revendication 1, **caractérisé en ce que** l'élément de liaison (9) entoure l'évidement (7) à l'extérieur sur tous les côtés.

5. Capteur MEMS selon la revendication 1, **caractérisé en ce que** la couche interne (5) comprend au moins une autre zone, notamment une autre zone servant d'électrode (17), notamment une autre zone entourée d'une tranchée d'isolation, notamment une tranchée d'isolation formée par l'évidement (7).

6. Capteur MEMS selon la revendication 1, **caractérisé en ce que**
- la couche intérieure (5) est reliée à la première couche (1) par l'intermédiaire d'une première couche de liaison (19), et
- la première couche de liaison (19) présente un évidement (21) qui libère la membrane de mesure (13) et forme une chambre de pression.

7. Capteur MEMS selon la revendication 1 ou 6, **caractérisé en ce que**
- la couche intérieure (5) comprend au moins une autre zone servant d'électrode (17), notamment une autre zone entourée d'une tranchée d'isolation, notamment une tranchée d'isolation formée par l'évidement (7),
- la couche intérieure (5) est reliée à la deuxième couche (3) par l'intermédiaire d'une deuxième couche de liaison (23) sous la forme d'une couche isolante, et
- l'électrode (17) est reliée à la deuxième couche (3) par l'intermédiaire de la deuxième couche de liaison (23), et
- l'électrode (17) est espacée de la première couche (1) en servant de contre-électrode à celle-ci.

8. Capteur MEMS selon la revendication 1, **caractérisé en ce que** le corps de base (15) comprend un évidement (25) s'étendant à travers le corps de base (15) et débouchant dans la chambre de pression.

9. Capteur MEMS selon la revendication 1 ou 8, **caractérisé en ce qu'**un autre corps de base (15), notamment un autre corps de base (15) de construction identique, est prévu sur un côté de la première couche (1) opposé au corps de base (15), lequel corps de base (15) est relié à la première couche (1) en incluant une chambre de pression.

10. Capteur MEMS selon l'une des revendications 1 à 9, **caractérisé en ce que** les zones d'extrémité arrondies présentent un rayon de courbure choisi en fonction de l'épaisseur de couche (d) de la couche interne respective (5), lequel rayon de courbure est supérieur ou égal à 1 µm, notamment supérieur ou égal à 5 µm, notamment supérieur ou égal à 10 µm.

11. Procédé destiné à la fabrication d'un capteur MEMS selon l'une des revendications précédente, **caractérisé en ce que** l'évidement (7) est créé par une combinaison d'un procédé de gravure anisotrope et d'un procédé de gravure isotrope.

12. Procédé selon la revendication 11, **caractérisé en ce que**
- au moyen d'un procédé de gravure anisotrope, notamment au moyen d'une gravure profonde par ions réactifs (DRIE), une tranchée (41), notamment une tranchée (41) avec des parois latérales s'étendant pour l'essentiel perpendiculairement à la couche interne (5), est réalisée dans la couche interne (5), laquelle tranchée s'étend dans la couche interne (5) jusqu'à une profondeur de gravure prédéterminée (h) mais ne la pénètre pas complètement, et
- au moyen d'un procédé de gravure isotrope, notamment au moyen d'une gravure ionique réactive (RIE), l'évidement (7) traversant la couche intérieure (5) est réalisé à partir de la tranchée (41).

13. Procédé selon la revendication 12, **caractérisé en ce que** la profondeur de gravure (h) est prédéfinie en fonction d'une épaisseur de couche (d) de la couche intérieure (5) de telle sorte qu'une différence entre l'épaisseur de couche (d) de la couche intérieure (5) et la profondeur de gravure (h) correspond à un rayon de courbure des zones d'extrémité arrondies à générer.
